# EUROPEAN PATENT SPECIFICATION

(11) **EP 0 500 034 B1**
(45) Date of publication and mention of the grant of the patent: **06.06.2001**
(21) Application number: 92102660.5
(22) Date of filing: 18.02.1992
(51) Int. Cl.: H01L 23/525

(54) **Sidewall anti-fuse structure and method for making**
Antischmelzsicherungsstruktur mit Seitenwand und Herstellungsverfahren
Structure d'antifusible à paroi latérale et procédé de fabrication

(30) Priority: 19.02.1991 US 657703
(43) Date of publication of application: 26.08.1992
(73) Proprietor: TEXAS INSTRUMENTS INCORPORATED, Dallas Texas 75265 (US)
(72) Inventor: Liu, David Kuan-Yu, Dallas, Texas 75287 (US); Chen, Kueing-Long, Plano, Texas 75093 (US); Riemenschneider, Bert R., Murphy, Texas 75074 (US)
(74) Representative: Schwepfinger, Karl-Heinz, Dipl.-Ing.

(56) References cited:
- EP-A- 0 250 078
- EP-A- 0 323 078
- US-A- 4 914 055

## Description

### Field of the Invention

The present invention relates to the field of integrated circuit technology. More specifically, the present invention relates to a semiconductor device including an anti-fuse.

### Background of the Invention

In integrated circuit fabrication, it is often desirable to allow a system whereby a user may customize an integrated circuit to their particular needs. Because of the great expense involved in designing specific integrated circuits for many specific tasks, programmable integrated circuits have been developed which allow the user to program the integrated circuit to his specific needs. An emerging type of programmable device are field programmable gate arrays (FPGAs). These devices provide large arrays of fusible type structures which allow the user to program the functional operation of the devices by altering the conductive state of these fusible devices. One such fusible device is called an anti-fuse. An anti-fuse operates in the opposite of the traditional meaning of the term "fuse". An anti-fuse is programmed by providing a voltage above a threshold determined by the characteristics of the device which causes a large current to pass through a dielectric layer between two conductive layers. After this threshold voltage has been reached, a conductive connection between the two conductive layers is permanently established. This is opposite the traditional meaning of a fuse in that when a high current is passed through a traditional fuse, the fuse is burned open and thus a conductive connection is broken. An example of the anti-fuse technology can be found in Mohsen, et. al., "Programmable Low

Impedance Anti-fuse Element", U.S. Patent 4,823,181 issued April 18, 1989. A field programmable gate array structure which utilises anti-fuse elements is described in Gamal et. al., "An Architecture For Electrically Configurable Gate Arrays", IEEE Journal of Solid State Circuits, Vol. 24, No. 2, Pgs. 394-398, (April 1989).

Anti-fuse structures have been disclosed in published European Patent Publications EP-A-0,250,078 A2 and EP-A-0,323,078 A2. Each of these anti-fuse structures is formed on a horizontal area of the top surface of the integrated circuit device which it is to interconnect. Therefore the density of devices on an integrated circuit structure is limited by photolithographic capabilities. Additionally, very thin dielectrics are used which results in a high capacitance between conductive leads in a gate array.

As in all integrated circuits, it is desirable to providc a circuit which operates as rapidly as possible. Prior art anti-fuse structures provide horizontal areas which arc limited by the lithography capabilities used to fabricate the integrated circuit. These devices arc in arrays with a very thin dielectric (6-20nm/60-200Å as disclosed in the Mohsen, et. Al. Patent). Because these dielcctrics must be very thin, a very high capacitance is provided between the conductive leads forming the gate array. In addition, because these are many of these devices along a particular lead, the resistive/capacitive (RC) time constant for a particular lead is very high. This creates a very large time lag from when a voltage is applied to a certain lead until the lead is charged up to the desired voltage. Thus it is desirable to minimise the capacitive coupling provided by an anti-fuse element. In addition, it is desirable to minimise the lateral area covered by an anti-fuse structure to allow for greater packing density of anti-fuse elements. This allows for shorter conductive leads for the same amount of anti-fuse elements as compared to the prior art structures. Because the anti-fuse leads are shorter, the resistance along the length of the lead is minimised and the RC constant is further reduced.

### SUMMARY OF THE INVENTION

An aspect of the present invention provides a semiconductor device including an anti-fuse as defined in claim 1. A further aspect of the invention is set forth in claim 7.

In some embodiments, said first and/or second conductive layers comprise polycrystalline silicon and a conductive material selected from the group of titanium, tungsten, molybdenum, platinum, titanium silicide, tungsten silicide, molybdenum silicide, platinum silicide, titanium nitride and combinations thereof.

Another aspect of the present invention provides a method for forming an anti-fuse on a semiconductor device, the method comprising the steps defined in claim 8.

Yet another aspect of the present invention provides a method of forming an array of anti-fuses comprising the steps defined in claim 14.

### Description of the Drawing

Figures 1 through 3 are side view schematic diagrams showing the processing steps, which comprise one embodiment of the present invention, used to fabricate another embodiment of the present invention;
Figures 4a through 6a and 4b through 6b are plan view diagrams with the associated side view schematic diagrams showing the processing steps, which comprise another embodiment of the present invention, used to fabricate an additional embodiment of the present invention.

### Detailed Description

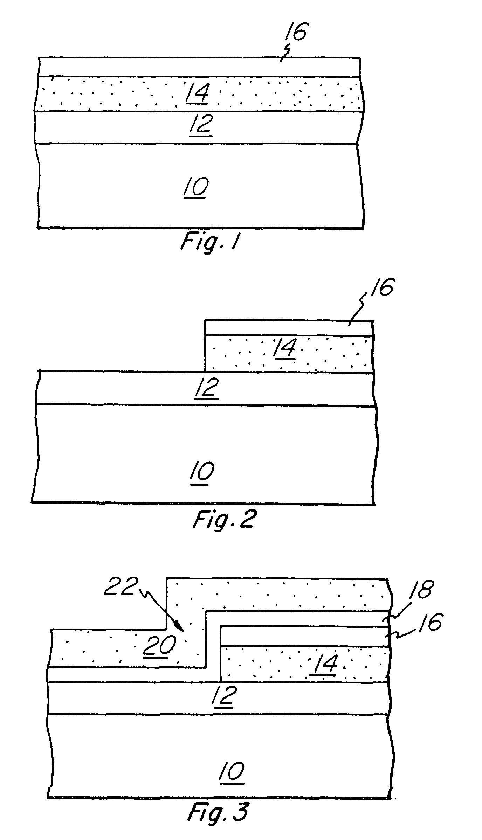

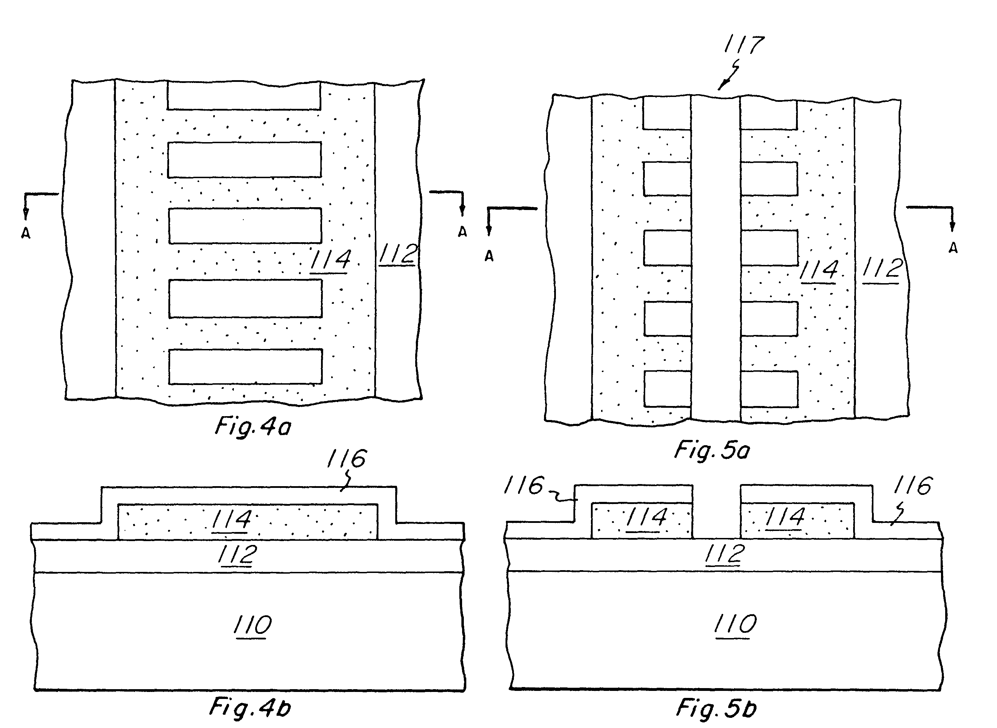

Figures 1-3 are a side view schematic diagrams showing the fabrication steps, which comprise one embodiment of the present invention, used to fabricate another embodiment of the present invention. Figures 4a-6a are plan view diagrams depicting the processing steps, which comprise another embodiment of the present invention, for fabricating yet another embodiment of the present invention. Figures 4b-6b are side view diagrams showing cutaway AA of plan view diagrams 4a-6a.

As shown in Figure 1, a substrate 10 is initially provided. Substrate 10 may be any of a number of materials but in this preferred embodiment compriscs crystalline silicon, thus allowing the fabrication of other devices such as transistors and diodes. Silicon dioxide layer 12 is formed on the surface of substrate 10 using thermal oxidation to a thickness of approximately 500nm (5000Å). Polycrystalline silicon layer 14 is formed on the surface of silicon dioxide layer 12 using chemical vapor deposition (CVD). Polycrystalline silicon layer 14 has a thickness of between 200-400nm (2000-4000Å) in this preferred embodiment. To provide additional conductivity and thus reduce the resistance of polycrystalline silicon, layer 14, additional materials such as titanium, tungsten, molybdenum, platinum, titanium silicide, tungsten silicide, molybdenum silicide, platinum silicide or titanium nitride may be incorporated into polycrystalline silicon layer 14 as additional layers or incorporated into the material itself. In addition, combinations of these materials or other highly conductive materials may be incorporated into polycrystalline silicon layer 14. The use of polycrystalline silicon in layer 14 is exemplary and many other materials will become apparent to those skilled in the art in light of this specification and arc considered within the scope of the present invention.

A thick silicon dioxide layer 16 is then formed on the surface of polycrystalline silicon 14. Silicon dioxide layer 16 may be formed by chemical vapor deposition or thermal oxidation of polycrystalline silicon layer 14. If thermal oxidation is used, then an additional thickness of polycrystalline silicon layer 14 must be provided to allow for consumption of this additional area by the thermal oxidation process. In the present embodiment, silicon dioxide layer 16 comprises approximately 200nm (2000Å) of silicon dioxide. In additional embodiments, silicon dioxide layer 16 may be other insulators or compound insulators to provide the function of silicon dioxide layer 16. The thickness of silicon dioxide layer 16 is provided to minimise the capacative coupling between conductive layers to be formed on the surface of silicon dioxide layer 16 and underlying polycrystalline silicon layer 14. Polycrystalline silicon layer 14 and silicon dioxide layer 16 are then patterned and etched to provide the structure shown in Figure 2. Preferably, this etching is accomplished using an anisotropic etching process using for example, a plasma of hydrofluoric acid to etch silicon dioxide layer 16 and a plasma of carbon tetrachloridc to etch polycrystalline silicon layer 14. This carbon tetrachloride etch is carcfully controlled by controlling the flow rates, temperature and plasma energy to provide a high rate of selectivity of polycrystalline silicon over silicon dioxide. The precise settings of the etching process are highly dependent upon the equipment used. This selectivity allows the etch to stop when the etch passes through polycrystalline silicon layer 14 to silicon dioxide layer 12. Although it is preferable to use a highly selective etch, this step is not critical in that silicon dioxide layer 12 is very thick and allows for some etching of silicon dioxide layer 12.

A dielectric layer 18 is then deposited on the surface of the structure of the Figure 2 as shown in Figure 3. A layer of silicon nitride is deposited on the surface of the structure of Figure 2. This is accomplished using chemical vapour deposition in an atmosphere such as silane and ammonia. The silicon nitride layer is then subjected to thermal oxidation in a steam ambient to provide an oxynitride layer on the surface of the silicon nitride layer. The combined effective thickness (i.e. relative to silicon dioxide) of dielectric layer 18 is approximately 6.5nm (65Å).

A polycrystalline silicon layer 20 is then deposited on the surface of dielectric layer 18. As with polycrystalline silicon layer 14, the materials and structures of polycrystalline silicon layer 20 may be modified to provide higher conductivity using the materials described with regard to polycrystalline silicon layer 14 or with other materials which will become obvious to those skilled in the art in light of this specification.

The use of the nitride-oxynitride (NO) dielectric provides a two-way characteristic for the breakdown of the anti-fuse provided on the vertical sidewall of polycrystalline silicon layer 14, dielectric layer 18 and polycrystalline silicon layer 20. This anti-fuse structure is indicated by the number 22 in Figure 3. When a positive potential is provided between polycrystalline silicon layer 20 and polycrystalline silicon layer 14 (i.e. a positive voltage of 0 volts is applied to polycrystalline silicon layer 14), dielectric layer 18 provides a breakdown voltage of approximately 13 1/2 volts. When the positive potential is applied to polycrystalline silicon layer 14, the breakdown voltage is approximately 10 1/2 volts.

Because anti-fuse 22 is formed on the sidewall of polycrystalline silicon layer 14, the interface area of anti-fuse 22 is the width of the anti-fuse in the thickness of the page times the thickness of polycrystalline layer 14. (The thickness is diminished slightly by the thickness of dielectri layer 18, but dielectric layer 18 is much thinner than polycrystalline silicon layer 14). Because one dimension of the anti-fuse interface area is defined by the thickness of polycrystalline silicon layer 14 rather than the minimum feature size allowed by the lithography used to fabricate the integrated circuit, the area of anti-fuse 22 is minimised. Because the area of anti-fuse 22 is minimised, the capacitive coupling between polycrystalline silicon layer 20 and polycrystalline silicon layer 14 is also minimized. Another important advantage is the small surface area required for this structure. Because the anti-fuse area is determined by the vertical edge of polycrystalline silicon layer 14, the area necessary for fabricating anti-fuse layer 22 is limited only by the alignment tolerance area required for a single edge. In prior art anti-fuse structures using a horizonal structure, the area which needed to be provided was the area of the anti-fuse itself plus alignment tolerances around the periphery of the anti-fuse. Thus, the anti-fuse of the present embodiment occupies a greatly reduced portion of the surface area of an integrated circuit incorporated the anti-fuse 22 as compared to that of the prior art.

Figures 4a-6a and 4b-6b are plan view diagrams with the associated schematic side view diagrams showing the processing steps of another embodiment of the present invention. Substrate 110 and silicon dioxide layer 112 are fabricated using similar processing steps as described with regard to substrate 10 and silicon dioxide layer 12, respectively, as described earlier. Polycrystalline silicon layer 114 is deposited using chemical vapor deposition. Polycrystalline layer 114 is then patterned using masking and anisotropic etching to provide the structure shown in Figure 4a. As can be seen, polycrystalline silicon layer 114 is patterned in a ladder type structure. This ladder structure allows for the fabrication of a large number of anti-fuse structures using relatively simplified processing steps. Thick silicon dioxide layer 116 is formed by chemical vapor deposition on the surface of silicon dioxide layer 112 and polycrystalline silicon layer 114. Silicon dioxide layer 116 is deposited after polycrystalline silicon layer 114 has been patterned. Silicon dioxide layer 116 is shown in Figure 4b but is omitted from the plan view of Figure 4a for clarity.

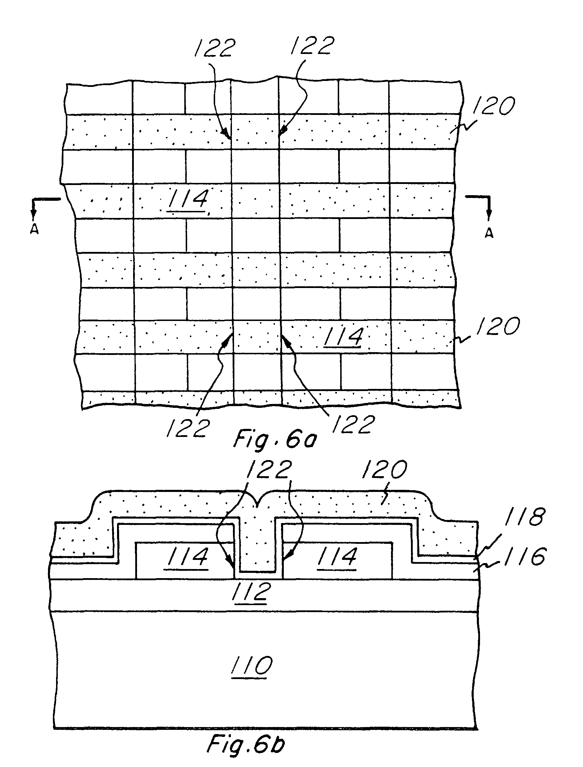

An etch mask (not shown) is then formed having a thin horizonal opening perpendicular to the "rungs" of the ladder structure of polycrystalline silicon layer 114. This etch mask is used to etch opening 117 as shown in Figure 5a. A plasma of hydrofluoric acid is used to etch silicon dioxide layer 116 and a plasma of carbon tetrachloride is used to etch polycrystalline silicon layer 114 down to silicon dioxide layer 112. As a part of this process the portions of silicon dioxide layer 116 between the rungs of the ladder will be etched away. The width of the rungs of the ladder are selected so as to allow alignment tolerances for opening 117 so that opening 117 will only intersect the rungs of the ladder and will not contact the edges, although some overlap may be tolerated. The resulting structure is shown in side view in Figure 5b. A dielectric layer 118 is then formed using the techniques described with regard to dielectric layer 18 on the surface of the structure of Figures 5a and 5b. A layer of polycrystalline silicon 120 is then deposited and patterned in a series of parallel strips overlapping the rungs of the ladder as shown in Figure 6a. Although polycrystalline silicon is used for layer 120, a number of conductive materials, particularly refractory metals and refractory metal silicides, may be employed. A schematic side view of this structure along cutaway AA is shown in Figure 6b. Perfect overlap between the rungs of the ladder of polycrystalline silicon layer 114 and the strips of polycrystalline silicon layer 120 is not necessary. Therefore, no additional alignment tolerance other than the minimum lithography dimension provided as the width of the rungs of the ladder is necessary. Thus, a plurality of anti-fuse elements 122 are fabricated using a highly compact array structure and providing a minimum of capacitive coupling between the conductive leads provided by polycrystalline silicon layer 120 and polycrystalline silicon layer 114.

Although specific embodiments of the present invention are described herein, they are not to be considered to be limiting to the scope of the present invention. The scope of the present invention is limited only by the claims appended hereto.

## Claims

1. A semiconductor device including an anti-fuse, said anti-fuse comprising:
a first conductive layer (14, 114) formed on a substrate and having a substantially planar major surface;
an insulating layer (16, 116) formed on the major surface, said insulating layer (16, 116) and said first conductive layer being arranged such that the first conductive layer has a substantially vertical sidewall;
a dielectric layer (18, 118) formed over at least said vertical sidewall, the thickness of the dielectric layer being less than that of the first conductive layer (14, 114) and the insulating layer (16, 116);
a second conductive layer (20, 120) formed overlying the dielectric layer (18, 118) such that the anti-fuse is substantially defined by a region of said dielectric layer formed on said vertical sidewall, said first conductive layer (14, 114) and said second conductive layer (20, 120) adjacent said dielectric layer (18, 118); and
wherein, the insulating layer (16, 116) has a thickness such that capacitive coupling between the major surface and the second conductive layer (20, 120) is substantially prevented.

2. A device as claimed in claim 1, wherein the dielectric layer (18, 118) is formed from a material selected from the group of materials containing silicon dioxide, silicon nitride or a combination thereof.

3. A device as claimed in any preceding claim, wherein the insulating layer (16, 116) is formed from silicon dioxide and has a thickness of approximately 200nm (2000Å).

4. A device as claimed in any preceding claim, wherein the dielectric layer (18, 118) has a thickness of 6.5nm (65Å) or less.

5. A device as claimed in any preceding claim, wherein the first conductive layer (14, 114) is formed on an insulator layer (12, 112) of said semiconductor device.

6. A device as claimed in any preceding claim, wherein the first and/or second conductive layers (14, 114, 20, 120) comprise polycrystalline silicon or polycrystalline silicon and a material selected from the group containing titanium, tungsten, molybdenum, platinum, titanium silicide, molybdenum silicide, platinum silicide, titanium nitride, and combinations thereof.

7. A device as claimed in any preceding claim comprising an array of anti-fuses, wherein the anti-fuses are arranged in rows and columns on the semiconductor device.

8. A method for forming an anti-fuse on a semiconductor device, the method comprising:
forming a first conductive layer (14, 114) on a substrate having a substantially planar major surface;
forming an insulating layer (16, 116) on the major surface, said insulating layer (16, 116) and said first conductive layer (14, 114) being arranged such that the first conductive layer (14, 114) has a substantially vertical sidewall;
forming a dielectric layer (18, 118) over at least the vertical sidewall, the thickness of the dielectric layer (18, 118) being less than that of the first conductive layer (14, 114) and the insulating layer (16, 116);
forming a second conductive layer (20, 120) overlying the dielectric layer (18, 118) such that the anti-fuse is substantially defined by a region formed on at least said vertical sidewall, said first conductive layer (14, 114) and said second conductive layer (20, 120) adjacent said dielectric layer (18, 118); and
forming the insulating layer (16, 116) to a thickness such that capacitive coupling between the major surface and the second conductive layer (20, 120) is substantially prevented.

9. A method as claimed in claim 8, wherein the method further comprises:
forming the dielectric layer (18, 118) from a material selected from the group of materials containing silicon dioxide, silicon nitride or combinations thereof.

10. A method as claimed in claim 8 or claim 9, further comprising:
forming the insulating layer (16, 116) from silicon dioxide to a thickness of approximately 200nm (2000Å).

11. A method as claimed in any of claims 8-10, further comprising:
forming the dielectric layer (18, 118) to a thickness of 6,5nm (65Å) or less.

12. A method as claimed in any of claims 8-11, further comprising:
forming the first conductive layer (14, 114) on an insulator layer (12, 112) of said semiconductor device.

13. A method as claimed in any of claims 8-12, further comprising:
forming the first and/or second conductive layers (14, 114, 20, 120) from polycrystalline silicon or polycrystalline silicon and a material selected from the group of materials containing titanium, tungsten, molybdenum, platinum, titanium silicide, molybdenum silicide, platinum silicide, titanium nitride and combinations thereof.

14. A method for forming an array of anti-fuses, the method comprising:
forming a first conductive layer (114) on a substrate such that it comprises a plurality of first conductive elements extending substantially parallel to one another in a first direction, each conductive element having a substantially planar major surface and a plurality of conductive extensions extending substantially perpendicular to said major surface;
forming an insulating layer (116) over the major surface of each first conductive element, said insulating layer (116) and each first conductive element being arranged such that each first conductive element has a substantially vertical sidewall;
forming a dielectric layer (118) over at least the vertical sidewall of each first conductive element, the thickness of the dielectric layer being less than that of the first conductive layer (114) and the insulating layer (116);
forming a second conductive layer (120) comprising a plurality of second conductive elements extending substantially parallel to one another and substantially perpendicular to the first conductive elements, the second conductive elements extending onto the dielectric layer (118) on each vertical sidewall in a region in which each second conductive element intersects each first conductive element thereby defining said anti-fuses; and
forming the insulating layer (116) to a thickness such that capacitive coupling between the major surfaces and the second conductive elements is substantially prevented.

## Patentansprüche

1. Halbleiterbauelement mit einer Antischmelzsicherung, welche aufweist:
eine erste leitende Schicht (14, 114), die auf einem Substrat ausgebildet ist und eine im wesentlichen planare Hauptfläche aufweist,
eine Isolierschicht (16, 116), die auf der Hauptfläche ausgebildet ist, wobei die Isolierschicht (16, 116) und die erste leitende Schicht so angeordnet sind, daß die erste leitende Schicht eine im wesentlichen vertikale Seitenwand aufweist,
eine dielektrische Schicht (18, 118), die über mindestens der vertikalen Seitenwand ausgebildet ist, wobei die Dicke der dielektrischen Schicht geringer als diejenige der ersten leitenden Schicht (14, 114) und der Isolierschicht (16, 116) ist,
eine zweite leitende Schicht (20, 120), die über der dielektrischen Schicht (18, 118) ausgebildet ist, so daß die Antischmelzsicherung im wesentlichen durch einen Bereich der an der vertikalen Seitenwand ausgebildeten dielektrischen Schicht, der ersten leitenden Schicht (14, 114) und der zweiten leitenden Schicht (20, 120) neben der dielektrischen Schicht (18, 118) festgelegt ist, und
wobei die Isolierschicht (16, 116) eine solche Dicke aufweist, daß die kapazitive Kopplung zwischen der Hauptfläche und der zweiten leitenden Schicht (20, 120) im wesentlichen verhindert ist.

2. Bauelement nach Anspruch 1, wobei die dielektrische Schicht (18, 118) aus einem Material besteht, das aus der Siliciumdioxid, Siliciumnitrid oder eine Kombination von diesen enthaltenden Gruppe von Materialien ausgewählt ist.

3. Bauelement nach einem der vorhergehenden Ansprüche, wobei die Isolierschicht (16, 116) aus Siliciumdioxid besteht und eine Dicke von etwa 200 nm (2000 Å) aufweist.

4. Bauelement nach einem der vorhergehenden Ansprüche, wobei die dielektrische Schicht (18, 118) eine Dicke von 6,5 nm (65 Å) oder weniger aufweist.

5. Bauelement nach einem der vorhergehenden Ansprüche, wobei die erste leitende Schicht (14, 114) auf einer Isolatorschicht (12, 112) des Halbleiterbauelements ausgebildet ist.

6. Bauelement nach einem der vorhergehenden Ansprüche, wobei die erste und/oder die zweite leitende Schicht (14, 114, 20, 120) polykristallines Silicium oder polykristallines Silicium und ein Material aufweist, das aus der Titan, Wolfram, Molybdän, Platin, Titansilicid, Molybdänsilicid, Platinsilicid, Titannitrid und Kombinationen von diesen enthaltenden Gruppe ausgewählt ist.

7. Bauelement nach einem der vorhergehenden Ansprüche mit einer Anordnung von Antischmelzsicherungen, wobei die Antischmelzsicherungen auf dem Halbleiterbauelement in Zeilen und Spalten angeordnet sind.

8. Verfahren zum Herstellen einer Antischmelzsicherung auf einem Halbleiterbauelement, aufweisend:
Bilden einer ersten leitenden Schicht (14, 114) auf einem Substrat mit einer im wesentlichen planaren Hauptfläche,
Bilden einer Isolierschicht (16, 116) auf der Hauptfläche, wobei die Isolierschicht (16, 116) und die erste leitende Schicht (14, 114) so angeordnet sind, daß die erste leitende Schicht (14, 114) eine im wesentlichen vertikale Seitenwand aufweist,
Bilden einer dielektrischen Schicht (18, 118) über mindestens der vertikalen Seitenwand, wobei die Dicke der dielektrischen Schicht (18, 118) geringer ist als diejenige der ersten leitenden Schicht (14, 114) und der Isolierschicht (16, 116),
Bilden einer zweiten leitenden Schicht (20, 120), die über der dielektrischen Schicht (18, 118) liegt, so daß die Antischmelzsicherung im wesentlichen durch einen auf mindestens der vertikalen Seitenwand, der ersten leitenden Schicht (14, 114) und der zweiten leitenden Schicht (20, 120) neben der dielektrischen Schicht (18, 118) ausgebildeten Bereich festgelegt ist, und
Bilden der Isolierschicht (16, 116) bis zu einer solchen Dicke, daß die kapazitive Kopplung zwischen der Hauptfläche und der zweiten leitenden Schicht (20, 120) im wesentlichen verhindert ist.

9. Verfahren nach Anspruch 8, weiter aufweisend:
Bilden der dielektrischen Schicht (18, 118) aus einem Material, das aus der Siliciumdioxid, Siliciumnitrid oder Kombinationen von diesen enthaltenden Gruppe von Materialien ausgewählt wird.

10. Verfahren nach Anspruch 8 oder 9, weiter aufweisend:
Bilden der Isolierschicht (16, 116) aus Siliciumdioxid bis zu einer Dicke von etwa 200 nm (2000 Å).

11. Verfahren nach einem der Ansprüche 8 - 10, weiter aufweisend:
Bilden der dielektrischen Schicht (18, 118) bis zu einer Dicke von 6,5 nm (65 Å) oder weniger.

12. Verfahren nach einem der Ansprüche 8 - 11, weiter aufweisend:
Bilden der ersten leitenden Schicht (14, 114) auf einer Isolatorschicht (12, 112) des Halbleiterbauelements.

13. Verfahren nach einem der Ansprüche 8 - 12, weiter aufweisend:
Bilden der ersten und/oder der zweiten leitenden Schicht (14, 114, 20, 120) aus polykristallinem Silicium oder polykristallinem Silicium und einem Material, das aus der Titan, Wolfram, Molybdän, Platin, Titansilicid, Molybdänsilicid, Platinsilicid, Titannitrid und Kombinationen von diesen enthaltenden Gruppe von Materialien ausgewählt wird.

14. Verfahren zum Herstellen einer Anordnung von Antischmelzsicherungen, aufweisend:
Bilden einer ersten leitenden Schicht (114) auf einem Substrat, so daß sie mehrere erste leitende Elemente aufweist, die in einer ersten Richtung im wesentlichen parallel zueinander verlaufen, wobei jedes leitende Element eine im wesentlichen planare Hauptfläche und mehrere leitende Vorsprünge aufweist, die im wesentlichen senkrecht zur Hauptfläche verlaufen,
Bilden einer Isolierschicht (116) über der Hauptfläche jedes ersten leitenden Elements, wobei die Isolierschicht (116) und jedes erste leitende Element so angeordnet sind, daß jedes erste leitende Element eine im wesentlichen vertikale Seitenwand aufweist,
Bilden einer dielektrischen Schicht (118) über mindestens der vertikalen Seitenwand jedes ersten leitenden Elements, wobei die Dicke der dielektrischen Schicht geringer ist als diejenige der ersten leitenden Schicht (114) und der Isolierschicht (116),
Bilden einer zweiten leitenden Schicht (120) mit mehreren zweiten leitenden Elementen, die im wesentlichen parallel zueinander und im wesentlichen senkrecht zu den ersten leitenden Elementen verlaufen, wobei sich die zweiten leitenden Elemente bis zur dielektrischen Schicht (118) auf jeder vertikalen Seitenwand in einem Bereich, in dem jedes zweite leitende Element jedes erste leitende Element schneidet, erstrecken, wodurch die Antischmelzsicherungen festgelegt werden, und
Bilden der Isolierschicht (116) bis zu einer solchen Dicke, daß die kapazitive Kopplung zwischen den Hauptflächen und den zweiten leitenden Elementen im wesentlichen verhindert ist.

## Revendications

1. Dispositif à semiconducteurs comprenant un dispositif anti-fusible, ledit dispositif anti-fusible comprenant:
une première couche conductrice (14, 114) formée sur un substrat et possédant une surface principale essentiellement plane;
une couche isolante (16, 116) formée sur la surface principale, ladite couche isolante (16, 116) et ladite première couche conductrice étant disposées de telle sorte que la première couche conductrice possède une paroi latérale essentiellement verticale;
une couche diélectrique (18, 118) formée sur au moins ladite paroi latérale verticale, l'épaisseur de la couche diélectrique étant inférieure à celle de la première couche conductrice (14, 114) et de la couche isolante (16, 116);
une seconde couche conductrice (20, 120) formée au-dessus de la couche diélectrique (18, 118) de telle sorte que le dispositif anti-fusible est défini essentiellement par une région de ladite couche diélectrique formée sur ladite paroi latérale verticale, ladite première couche conductrice (14, 114) et ladite seconde couche conductrice (20, 120) au voisinage de ladite couche diélectrique (18, 118); et
dans lequel la couche isolante (16, 116) possède une épaisseur telle que le couplage capacitif entre la surface principale et la seconde couche conductrice (20, 120) est empêché pour l'essentiel.

2. Dispositif selon la revendication 1, dans lequel la couche diélectrique (18, 118) est formée d'un matériau choisi dans le groupe de matériau comprenant le bioxyde de silicium, le nitrure de silicium ou une combinaison de ces matériaux.

3. Dispositif selon l'une quelconque des revendications précédentes, dans lequel la couche isolante (16, 116) est formée de bioxyde de silicium et possède une couche d'environ 200 nm (2000 Å).

4. Dispositif selon l'une quelconque des revendications précédentes, dans lequel - la couche diélectrique (18, 118) possède une épaisseur de 6,5 nm (65 Å) ou moins.

5. Dispositif selon l'une quelconque des revendications précédentes, dans lequel la première couche conductrice (14, 114) est formée sur une couche isolante (12, 112) dudit dispositif à semiconducteurs.

6. Dispositif selon l'une quelconque des revendications précédentes, dans lequel les première et/ou seconde couches conductrices (14, 114, 20, 120) comprennent du silicium polycristallin ou du silicium polycristallin et un matériau choisi dans le groupe comprenant le titane, le tungstène, le molybdène, le platine, le siliciure de titane, le siliciure de molybdène, le siliciure de platine, le nitrure de titane et des combinaisons de ces produits.

7. Dispositif selon l'une quelconque des revendications précédentes, comprenant un réseau de dispositifs anti-fusibles, dans lequel les dispositifs anti-fusibles sont disposés suivant des rangées et colonnes sur le dispositif à semiconducteurs.

8. Procédé pour former un dispositif anti-fusible sur un dispositif à semiconducteur, le procédé comprenant:
la formation d'une première couche conductrice (14, 114) sur un substrat possédant une surface principale essentiellement plane;
la formation d'une couche isolante (16, 116) sur la surface principale, ladite couche isolante (16, 116) et ladite première couche conductrice (14, 114) étant agencées de telle sorte que la première couche conductrice (14, 114) possède des parois latérales essentiellement verticales;
la formation d'une couche diélectrique (18, 118) sur au moins la paroi latérale verticale, l'épaisseur de la couche diélectrique (18, 118) étant inférieure à celle de la première couche conductrice (14, 114) et de la couche isolante (16, 116);
la formation d'une seconde couche conductrice (20, 120) recouvrant la couche diélectrique (18, 118) de telle sorte que le dispositif anti-fusible est défini essentiellement par une région formée sur au moins ladite paroi latérale verticale, ladite première couche conductrice (14, 114) et ladite seconde couche conductrice (20, 120) au voisinage de ladite couche diélectrique (18, 118); et
la formation de la couche isolante (16, 116) sur une épaisseur telle qu'un couplage capacitif entre la couche principale et la seconde conductrice (20, 120) est empêché pour l'essentiel.

9. Procédé selon la revendication 8, selon lequel le procédé comprend en outre:
la formation de la couche diélectrique (18, 118) en un matériau choisi dans le groupe de matériaux comprenant le bioxyde de silicium, le nitrure de silicium ou des combinaisons de ces matériaux.

10. Procédé selon la revendication 8 ou la revendication 9, comprenant en outre:
la formation de la couche isolante (16, 116) à partir du bioxyde de silicium sur une épaisseur d'environ 200 nm (2000 Å).

11. Procédé selon l'une quelconque des revendications 8-10, comprenant en outre:
la formation de la couche diélectrique (18, 118) sur une épaisseur de 6,5 nm (65 Å) ou moins.

12. Procédé selon l'une quelconque des revendications 8-11, comprenant en outre:
la formation de la première couche conductrice (14, 114) sur une couche isolante (12, 112) dudit dispositif à semiconducteurs.

13. Procédé selon l'une quelconque des revendications 8-12, comprenant en outre:
la formation des première et/ou seconde couches conductrices (14, 114, 20, 120) en silicium polycristallin ou en silicium polycristallin et un matériau choisi dans le groupe comprenant le titane, le tungstène, le molybdène, le platine, le siliciure de titane, le siliciure de molybdène, le siliciure de platine, le nitrure de titane et des combinaisons de ces produits.

14. Procédé pour former un réseau de dispositifs anti-fusibles, le procédé comprenant:
la formation d'une première couche conductrice (114) sur un substrat de telle sorte qu'elle comprend une pluralité de premiers éléments conducteurs s'étendant essentiellement parallèlement entre eux dans une première direction, chaque élément conducteur possédant une surface principale essentiellement plane et une pluralité de prolongements conducteurs s'étendant essentiellement perpendiculairement à ladite surface principale;
la formation d'une couche isolante (116) sur la surface principale de chaque premier élément conducteur, ladite couche isolante (116) et chaque premier élément conducteur étant agencés de telle sorte que chaque premier élément conducteur possède une paroi latérale essentiellement verticale;
la formation d'une couche diélectrique (118) sur au moins la paroi latérale verticale de chaque premier élément conducteur, l'épaisseur de la couche diélectrique étant inférieure à celle de la première couche conductrice (114) et de la couche isolante (116);
la formation d'une seconde couche conductrice (120) comprenant une pluralité de seconds éléments conducteurs s'étendant essentiellement parallèlement entre eux et essentiellement perpendiculairement aux premiers éléments conducteurs, les seconds éléments conducteurs s'étendant sur la couche diélectrique (118) sur chaque paroi latérale verticale dans une région dans laquelle chaque second élément conducteur intersecte chaque premier élément conducteur définissant lesdits dispositifs anti-fusibles; et
la formation de la couche isolante (116) sur une épaisseur telle qu'un couplage capacitif entre les surfaces principales et les seconds éléments conducteurs est empêché pour l'essentiel.
